(19) Europäisches Patentamt
European Patent Office
Office européen des brevets

(11) Veröffentlichungsnummer: **0 222 320 B1**

# (12) EUROPÄISCHE PATENTSCHRIFT

(45) Veröffentlichungstag der Patentschrift: **28.10.92**

(51) Int. Cl.$^5$: **G03F 7/027**

(21) Anmeldenummer: **86115360.9**

(22) Anmeldetag: **06.11.86**

## (54) Durch Strahlung polymerisierbares Gemisch, daraus hergestelltes Aufzeichnungsmaterial und Verfahren zur Herstellung von Reliefaufzeichnungen.

(30) Priorität: **15.11.85 DE 3540480**

(43) Veröffentlichungstag der Anmeldung:
**20.05.87 Patentblatt 87/21**

(45) Bekanntmachung des Hinweises auf die Patenterteilung:
**28.10.92 Patentblatt 92/44**

(84) Benannte Vertragsstaaten:
**AT BE CH DE FR GB IT LI**

(56) Entgegenhaltungen:
**EP-A- 0 036 813**
**EP-A- 0 037 314**
**EP-A- 0 098 982**
**DE-A- 1 522 463**
**US-A- 3 957 561**
**US-A- 4 111 769**
**US-A- 4 227 980**
**US-A- 4 424 100**
**US-A- 4 439 600**

(73) Patentinhaber: **HOECHST AKTIENGESELLSCHAFT**
**Postfach 80 03 20**
**W-6230 Frankfurt am Main 80(DE)**

(72) Erfinder: **Geissler, Ulrich, Dr. Dipl.-Chem.**
**Altenauer Strasse 34**
**W-6203 Hochheim/Main(DE)**
Erfinder: **Steppan, Hartmut, Dr. Dipl.-Chem.**
**Panoramastrasse 17**
**W-6200 Wiesbaden(DE)**
Erfinder: **Herwig, Walter, Dr. Dipl.-Chem.**
**Hasenpfad 7**
**W-6232 Bad Soden/Taunus(DE)**

**EP 0 222 320 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein durch Strahlung polymerisierbares Gemisch, das als wesentliche Bestandteile

a) ein polymeres Bindemittel, das wasserunlöslich und in wäßrig-alkalischen Lösungen löslich oder mindestens quellbar ist oder das ein Polyacrylsäureester oder Polymethacrylsäureester ist,

b) ein radikalisch polymerisierbares Acryl- oder Alkacrylsäurederivat mit einem Siedepunkt oberhalb 100° C bei Normaldruck und

c) eine Verbindung oder eine Verbindungskombination enthält, die unter Einwirkung aktinischer Strahlung die Polymerisation der Verbindung b) zu initiieren vermag.

Das Gemisch ist insbesondere zur Herstellung von Photoresists geeignet, vor allem von solchen, die nach dem Trockenresistverfahren hergestellt und verarbeitet werden können.

Gemische der vorstehend genannten Art sind bekannt. In den US-A 3 887 450 und 3 953 309 werden photopolymerisierbare Gemische zur Anwendung bei dem Trockenresistverfahren beschrieben, die mit wäßrig-alkalischen Lösungen entwickelt werden können und die als polymerisierbare Verbindungen vorzugsweise ausschließlich solche mit zwei oder mehr polymerisierbaren ethylenisch ungesättigten Gruppen enthalten.

Aus der EP-A 128 014 sind ähnliche Gemische bekannt, die zusätzlich eine einfach ungesättigte polymerisierbare Verbindung, insbesondere ein Aryloxypolyalkoxyalkyl(meth)acrylat, enthalten. Durch diesen Zusatz sollen Biegsamkeit, Klebrigkeit und Entwickelbarkeit der Schichten verbessert werden; auch die Entschichtung der belichteten Schichtbereiche wird dadurch erleichtert.

Aus der DE-A 3 441 787 sind Gemische gleicher Art und Anwendbarkeit beschrieben, die ein- oder mehrfach ungesättigte Monomere enthalten, von denen mindestens eines eine aromatische OH-, SH- oder Sulfonamidgruppe enthält. Diese Gemische zeichnen sich insbesondere durch eine leichte Entschichtbarkeit nach dem Belichten aus.

Allgemein ist es üblich, in Trockenphotoresistschichten Monomere einzusetzen, die Urethangruppen enthalten. Gemische dieser Art sind z. B. in den US-A 3 850 770, 4 019 972, 4 088 498, 4 250 248, und 4 387 139 beschrieben. In allen diesen Fällen handelt es sich um mehrfach, zumeist zweifach ungesättigte Verbindungen.

In der US-A 3 783 151 sind ähnliche Gemische auf Basis von Urethangruppen enthaltenden mehrfach ungesättigten polymerisierbaren Verbindungen beschrieben, die zur Herstellung von strahlungshärtbaren Lacken und Druckfarben dienen. Die Urethangruppen können durch Umsetzen mit ein- oder mehrwertigen Isocyanaten eingeführt werden; wenn einwertige Isocyanate eingesetzt werden, werden sie stets mit mehrfach ungesättigten Monomeren, z. B. mit Pentaerythrittriacrylat, umgesetzt.

In der US-A 4 227 980 werden lichthärtbare Lacke beschrieben, die (Meth)acrylsäureester mit nur einer polymerisierbaren Gruppe enthalten. Die Gemische sind flüssig und zur Herstellung von lagerfähig vorbeschichteten lichtempfindlichen Materialien nicht geeignet.

In der EP-A 98 982 sind photopolymerisierbare Gemische aus mehrfach ungesättigten (Meth)-acrylsäureestern und alkalilöslichen Bindemitteln für die Herstellung von Druckplatten und Photoresists beschrieben. Die polymerisierbaren Verbindungen enthalten keine Urethangruppen.

Die oben beschriebenen Trockenphotoresistmaterialien mit einem Gehalt an monofunktionellen ungesättigten Verbindungen weisen zwar eine verbesserte Flexibilität und Entschichtbarkeit im belichteten Zustand auf. Sie haben jedoch andere Nachteile, die ihre Brauchbarkeit in der Praxis einschränken. So neigen manche der Monomeren zur Kristallisation, in anderen Fällen sind die belichteten Schichten zu spröde oder sie weisen eine nicht ausreichende Haftung auf Kupfer im unbelichteten Zustand auf.

Aufgabe der Erfindung war es, durch Strahlung polymerisierbare Gemische bereitzustellen, die eine gute Flexibilität, Entwickelbarkeit und Entschichtbarkeit nach dem Belichten aufweisen und sich weiterhin gegenüber bekannten Gemischen, die diese Eigenschaft haben, durch eine geringere Sprödigkeit und bessere Haftung auf Kupfer auszeichnen.

Erfindungsgemäß wird ein durch Strahlung polymerisierbares Gemisch vorgeschlagen, das als wesentliche Bestandteile

a) ein polymeres Bindemittel, das wasserunlöslich und in wäßrig-alkalischen Lösungen löslich oder mindestens quellbar ist oder das ein Polyacrylsäureester oder Polymethacrylsäureester ist,

b) ein radikalisch polymerisierbares Acryl- oder Alkacrylsäurederivat mit einem Siedepunkt oberhalb 100° C bei Normaldruck und

c) eine Verbindung oder eine Verbindungskombination, die unter Einwirkung aktinischer Strahlung die Polymerisation der Verbindung b) zu initiieren vermag,

enthält.

Das erfindungsgemäße Gemisch ist dadurch gekennzeichnet, daß das Acryl- oder Alkacrylsäurederivat

eine Verbindung der Formel I

$$CH_2 = \overset{R^1}{\overset{|}{C}} - CO - A - (C_mH_{2m}O)_n - (Q)_l - CO - NHR^2 \quad (I)$$

ist, worin

- A O, NH oder N-Alkyl,
- Q $-CO-C_pH_{2p}-Z-$ oder $-C_kH_{2k}O-$,
- Z O oder NH,
- $R^1$ H oder Alkyl,
- $R^2$ Alkyl, Alkenyl, Cycloalkyl, Aryl, Aralkyl oder $SO_2R^3$,
- $R^3$ Alkyl, Alkenyl, Cycloalkyl, Aryl, Aralkyl oder Aryloxy,
- k eine Zahl von 3 bis 20,
- l eine Zahl von 0 bis 20,
- m eine Zahl von 2 bis 20,
- n eine Zahl von 1 bis 20 und
- p eine Zahl von 2 bis 10

bedeutet.

Erfindungsgemäß wird ferner ein durch Strahlung polymerisierbares Aufzeichnungsmaterial mit einem flexiblen transparenten temporären Schichtträger und einer übertragbaren thermoplastischen durch Strahlung polymerisierbaren Photoresistschicht, die als wesentliche Bestandteile

a) ein polymeres Bindemittel, das wasserunlöslich und in wäßrig-alkalischen Lösungen löslich oder mindestens quellbar ist oder das ein Polyacrylsäureester oder Polymethacrylsäureester ist,

b) ein radikalisch polymerisierbares Acryl- oder Alkacrylsäurederivat mit einem Siedepunkt oberhalb 100° C bei Normaldruck und

c) eine Verbindung oder eine Verbindungskombination, die unter Einwirkung aktinischer Strahlung die Polymerisation der Verbindung b) zu initiieren vermag,

enthält, und gegebenenfalls einem abziehbaren Deckblatt auf der freien Seite der Photoresistschicht vorgeschlagen, das an der Schicht weniger stark haftet als der temporäre Schichtträger.

Das erfindungsgemäße Aufzeichnungsmaterial ist dadurch gekennzeichnet, daß das Acryl-oder Alkacrylsäurederivat eine Verbindung der Formel I

$$CH_2 = \overset{R^1}{\overset{|}{C}} - CO - A - (C_mH_{2m}O)_n - (Q)_l - CO - NHR^2 \quad (I)$$

ist, worin

- A O, NH oder N-Alkyl,
- Q $-CO-C_pH_{2p}-Z-$ oder $-C_kH_{2k}O-$,
- Z O oder NH,
- $R^1$ H oder Alkyl,
- $R^2$ Alkyl, Alkenyl, Cycloalkyl, Aryl, Aralkyl oder $SO_2R^3$,
- $R^3$ Alkyl, Alkenyl, Cycloalkyl, Aryl, Aralkyl oder Aryloxy,
- k eine Zahl von 3 bis 20,
- l eine Zahl von 0 bis 20,
- m eine Zahl von 2 bis 20,
- n eine Zahl von 1 bis 20 und
- p eine Zahl von 2 bis 10

bedeutet.

Erfindungsgemäß wird weiterhin ein Verfahren zur Herstellung von Reliefaufzeichnungen vorgeschlagen, bei dem man eine trockene, feste, durch Strahlung polymerisierbare Photoresistschicht, die als wesentliche

Bestandteile

a) ein polymeres Bindemittel, das wasserunlöslich und in wäßrig-alkalischen Lösungen löslich oder mindestens quellbar ist oder das ein Polyacrylsäureester oder Polymethacrylsäureester ist,

b) ein radikalisch polymerisierbares Acryl- oder Alkacrylsäurederivat mit einem Siedepunkt oberhalb 100° C bei Normaldruck und

c) eine Verbindung oder eine Verbindungskombination, die unter Einwirkung aktinischer Strahlung die Polymerisation der Verbindung b) zu initiieren vermag,

enthält und die sich auf einem flexiblen transparenten temporären Schichtträger befindet, unter Druck und Erwärmen auf einen endgültigen Schichtträger laminiert, bildmäßig bestrahlt, den temporären Schichtträger abzieht und die unbestrahlten Schichtbereiche mit einem Entwickler auswäscht.

Das erfindungsgemäße Verfahren ist dadurch gekennzeichnet, daß die Photoresistschicht als radikalisch polymerisierbares Acryl- oder Alkacrylsäurederivat eine Verbindung der Formel I

$$CH_2 = \overset{\overset{R^1}{|}}{C} - CO - A - (C_mH_{2m}O)_n - (Q)_l - CO - NHR^2 \qquad (I)$$

enthält, worin

| | |
|---|---|
| A | O, NH oder N-Alkyl, |
| Q | $-CO-C_pH_{2p}-Z-$ oder $-C_kH_{2k}O-$, |
| Z | O oder NH, |
| $R^1$ | H oder Alkyl, |
| $R^2$ | Alkyl, Alkenyl, Cycloalkyl, Aryl, Aralkyl oder $SO_2R^3$, |
| $R^3$ | Alkyl, Alkenyl, Cycloalkyl, Aryl, Aralkyl oder Aryloxy, |
| k | eine Zahl von 3 bis 20, |
| l | eine Zahl von 0 bis 20, |
| m | eine Zahl von 2 bis 20, |
| n | eine Zahl von 1 bis 20 und |
| p | eine Zahl von 2 bis 10 |

bedeutet.

Monofunktionelle polymerisierbare Verbindungen, darunter auch solche der Formel I, sind an sich bekannt und als Bestandteile von photohärtbaren Überzugsmassen, Lacken oder Klebern z. B. in den US-A 3 957 561, 4 111 769, 4 227 980, 4 424 100, 4 439 600 und den EP-A 36 813 und 37 314 beschrieben. Von diesen bekannten Verbindungen eignen sich diejenigen der Formel I entsprechend der oben gegebenen Definition für den Einsatz in dem erfindungsgemäßen Gemisch.

In der allgemeinen Formel I ist $R^1$ bevorzugt ein Wasserstoffatom oder eine Methylgruppe.

$R^2$ hat bevorzugt mindestens 4 Kohlenstoffatome. Wenn $R^2$ ein Alkyl- od Alkenylrest ist, hat dieser vorzurgsweise in gerader Kette 4 bis 12 Kohlenstoffatome. Als Cycloalkylreste werden solche mit 5 oder 6 Ringgliedern bevorzugt, die gegebenenfalls durch Alkyl-oder Alkoxygruppen mit 1 bis 3 Kohlenstoffatomen substituiert sein können. Als Arylreste werden insbesondere substituierte oder unsubstituierte Phenylreste eingesetzt. Als Substituenten kommen vorzugsweise Alkyl-, Alkoxy- oder Alkylendioxygruppen mit 1 bis 4 Kohlenstoffatomen in Betracht.

$R^3$ ist bevorzugt ein Alkyl-, Aryl- oder Aryloxyrest, insbesondere ein Alkylrest mit 2 bis 8 Kohlenstoffatomen oder ein einkerniger Aryl- oder Aryloxyrest mit 6 bis 10 Kohlenstoffatomen.

Wenn A eine N-Alkyl-Gruppe ist, hat diese bevorzugt 1 bis 6 Kohlenstoffatome.

A und Z sind besonders bevorzugt Sauerstoffatome.

Vorzugsweise bedeutet k eine Zahl von 3 bis 10, insbesondere von 3 bis 6; l ist bevorzugt 0 bis 10; m ist bevorzugt 2 bis 10, insbesondere 2 bis 4; n ist bevorzugt 1 bis 15, besonders bevorzugt 1 bis 10; und p ist bevorzugt 3 bis 6.

Die bevorzugten monofunktionellen Monomeren sollen unter den Herstellungs- und Lagerungsbedingungen des Gemischs praktisch nicht flüchtig sein und bei der Lagerung des Gemischs nicht kristallisieren.

Beispiele für geeignete Monomere sind die Umsetzungsprodukte von Isocyanaten mit Hydroxyethylacrylat oder -methacrylat oder mit den Reaktionsprodukten, die durch Umsetzen von Hydroxyethyl(meth)-acrylat mit Alkylenoxiden oder Lactamen oder Lactonen von Amino- oder Hydroxycarbonsäuren, z. B. Caprolactam oder Caprolacton, erhalten werden.

Weniger bevorzugt wird das Umsetzungsprodukt von Hydroxyethylmethacrylat mit tert.-Butylisocyanat, da es in den meisten Gemischen zur Flüchtigkeit neigt.

Auch werden die Umsetzungsprodukte von Hydroxyethylmethacrylat mit halogenierten Phenylisocyanaten, wie 4-Chlor- oder 3-Chlor-4-methyl-phenylisocyanat oder mit Naphthylisocyanaten wegen ihrer Kristallisationsneigung nicht bevorzugt.

Die erfindungsgemäßen Gemische können zusätzlich zu den monofunktionellen Monomeren polymerisierbare Verbindungen mit mindestens zwei endständigen ethylenischen Doppelbindungen enthalten. Als derartige mehrfunktionelle Verbindungen werden im allgemeinen Ester der Acryl- oder Methacrylsäure mit mehrwertigen, vorzugsweise primären, Alkoholen verwendet. Beispiele für geeignete mehrwertige Alkohole sind Ethylenglykol, Propylenglykol, Butandiol-1,4, Butandiol-1,3, Diethylenglykol, Triethylenglykol, Polyethylenglykole oder Polypropylenglykole mit Molekulargewichten von etwa 200 bis 1.000, Neopentylglykol, Trimethylolethan und -propan, Pentaerythrit und oxyethylierte Bisphenol-A-Derivate. Geeignet sind auch Urethangruppen enthaltende Bisacrylate und Bismethacrylate, die durch Umsetzung von Diisocyanaten mit Partialestern mehrwertiger Alkohole und ggf. Diolen oder Polyolen erhalten werden. Derartige Urethangruppen enthaltende Monomere sind in den DE-A 20 64 079, 23 61 041 und 28 22 190 beschrieben. Ähnliche Monomere sind in der DE-A 30 48 502 beschrieben.

Die Gesamtmenge an polymerisierbaren Verbindungen in dem erfindungsgemäßen Gemisch beträgt im allgemeinen 25 bis 75, vorzugsweise 40 bis 60 Gew.-% bezogen auf die nichtflüchtigen Bestandteile des Gemischs. Der Anteil an monofunktionellen Monomeren beträgt im allgemeinen 5 bis 100, bevorzugt 20 bis 95, besonders bevorzugt 55 - 95 Gew.-%, bezogen auf die Gesamtmenge an polymerisierbaren Verbindungen.

Als durch Strahlung, insbesondere aktinisches Licht aktivierbare Polymerisationsinitiatoren in dem erfindungsgemäßen Gemisch können eine Vielzahl von Substanzen Verwendung finden. Beispiele sind Benzoin und seine Derivate, Trichlormethyl-s-triazine, Trihalogenmethylgruppen enthaltende Carbonylmethylenheterocyclen, z. B. 2-(p-Trichlormethyl-benzoylmethylen)-3-ethyl-benzthiazolin, Acridinderivate, z. B. 9-Phenyl-acridin, 9-p-Methoxy-phenyl-acridin, 9-Acetylamino-acridin, Benz(a)acridin; Phenazinderivate, z. B. 9,10-Dimethylbenz(a)phenazin, 10-Methoxy-benz(a)phenazin, Chinoxalinderivate, z. B. 6,4',4"-Trimethoxy-2,3-diphenylchinoxalin, 4',4"-Dimethoxy-2,3-diphenyl-5-azachinoxalin oder Chinazolinderivate. Die Initiatoren werden allgemein in einer Menge von 0,01 bis 10, vorzugsweise von 0,05 bis 4 Gew.-%, bezogen auf die nicht flüchtigen Bestandteile des Gemisches, eingesetzt.

Als Bindemittel können Polyacrylsäureester oder Polymethacrylsäureester eingesetzt werden.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Styrol-Maleinsäureanhydrid-Mischpolymerisate. Alkylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-A 20 64 080 und 23 63 806 beschrieben sind, werden bevorzugt. Besonders bevorzugt werden höhermolekulare Mischpolymerisate, wie sie in der älteren, nicht vorveröffentlichten EP-A 173 057 beschrieben sind.

Die Menge des Bindemittels beträgt im allgemeinen 25 bis 75, vorzugsweise 40 bis 60 Gew.-% der Bestandteile des Gemischs.

Das Gemisch kann als übliche weitere Bestandteile Polymerisationsinhibitoren, Wasserstoffdonatoren, sensitometrische Regler, Farbstoffe, Pigmente, Weichmacher und thermisch aktivierbare Vernetzungsmittel enthalten.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen- und Elektronenstrahlung. Auch Laserstrahlung im sichtbaren und UV-Bereich kann verwendet werden. Bevorzugt wird kurzwelliges sichtbares und nahes UV-Licht.

Als Schichtträger für mit dem erfindungsgemäßen Gemisch hergestellte Aufzeichnungsmaterialien sind beispielsweise Aluminium, Stahl, Zink, Kupfer, Siebe oder Kunststoffolien, z. B. aus Polyethylenterephthalat, geeignet. Die Trägeroberfläche kann chemisch oder mechanisch vorbehandelt werden, um die Haftung der Schicht richtig einzustellen.

Das erfindungsgemäße Gemisch findet bevorzugt Anwendung als trocken übertragbares Photoresistmaterial. Dazu kann es in bekannter Weise als vorgefertigte, übertragbare Trockenresistfolie auf das zu

bearbeitende Werkstück, z. B. auf Leiterplatten-Basismaterial, aufgebracht werden. Im allgemeinen wird zur Herstellung des Trockenresistmaterials eine Lösung des Gemisches in einem Lösemittel auf einen geeigneten Schichtträger, z. B. eine Polyesterfolie, aufgebracht und getrocknet. Die Schichtdicke der Resistschicht kann etwa 10 bis 80, vorzugsweise 20 bis 60 µm betragen. Die freie Oberfläche der Schicht wird vorzugsweise mit einer Deckfolie, z. B. aus Polyethylen oder Polypropylen, abgedeckt. Das fertige Laminat kann als Großrolle gespeichert und bei Bedarf zu Resistrollen beliebiger Breite zerschnitten werden.

Die Folien lassen sich mit in der Trockenresisttechnik üblichen Geräten verarbeiten. In einer handelsüblichen Laminiervorrichtung wird die Deckfolie abgezogen und die Photoresistschicht auf kupferkaschiertes Basismaterial auflaminiert. Die so präparierte Platte wird dann durch eine Vorlage belichtet und nach Abziehen der Trägerfolie in bekannter Weise entwickelt.

Als Entwickler sind z. B. wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-% an mit Wasser mischbaren organischen Lösungsmitteln oder Netzmitteln zugesetzt werden können. Wenn Bindemittel eingesetzt werden, die in wäßrig-alkalischen Lösungen nicht löslich sind, werden auch organische Lösungsmittel, z. B. Trichlorethan, verwendet.

Die erfindungsgemäßen Gemische lassen sich für die verschiedensten Anwendungsgebiete einsetzen. Mit besonderem Vorteil werden sie in Form eines Trockenresistfilms zur Herstellung von Reservagen, d. h. Ätzshutzschichten oder Galvanoreserven, auf metallischen Trägern, z. B. Kupfer, verwendet.

Bei dieser Anwendung kommt die herausragende Elastizität und Zähigkeit der aus dem erfindungsgemäßen Gemisch hergestellten Photoresistschichten sowohl im unbelichteten als auch im belichteten Zustand zur Geltung. Die auf Kupfer laminierte photopolymerisierbare Schicht hat einen so festen Zusammenhalt, daß die freitragenden, die Löcher überdeckenden Schichtbereiche beim Abtrennen der Trägerfolie unbeschädigt bleiben und nicht von dieser Folie mitgerissen werden. Es ist mit Schichten aus dem erfindungsgemäßen Gemisch möglich, Löcher von 6 mm Durchmesser und darüber zu überspannen, wobei die Schicht beim Abtrennen der Folie, beim Entwickeln, Galvanisieren und bzw. oder Ätzen unbeschädigt bleibt.

Im Vergleich zu bekannten Trockenresistschichten mit ausschließlich zwei- oder mehrfunktionellen Monomeren haben die aus den erfindungsgemäßen Gemischen bestehenden Schichten den Vorteil einer besseren Haftung auf Kupfer, einer geringeren Sprödigkeit im belichteten Zustand und einer leichteren Entschichtbarkeit nach der Verarbeitung. Sie weisen im Vergleich zu bekannten Trockenresistschichten, die sowohl monofunktionelle als auch mehrfuntionelle Monomere enthalten, eine bessere Haftung auf Kupfer im belichteten und unbelichteten Zustand und - gegenüber einigen dieser bekannten Gemische - eine geringer Kristallisationsneigung auf.

Die erfindungsgemäßen Gemische ergeben Schichten mit hoher Flexibilität im unbelichteten und belichteten Zustand, so daß sich die daraus hergestellten Resistschablonen leicht und zuverlässig korrigieren bzw. retuschieren lassen. Die Schichten lassen sich in kurzer Zeit rückstandsfrei entwickeln und bilden bei der Entschichtung im lichtgehärteten Zustand kleinere Fladen. Im Gegensatz zu den meisten bekannten, monofunktionelle Monomer enthaltenden Trockenresistmaterialien können auch solche erfindungsgemäßen Gemische mit Vorteil eingesetzt werden, die ausschließlich monofunktionelle Monomere enthalten.

Diese Schichten haben den Vorteil, daß sie sich nach dem Entschichten (Strippen) im belichteten Zustand in der Entschichtungslösung nach einiger Zeit vollständig auflösen, also keine Fladen hinterlassen. Es ist deshalb auch möglich, alkalische Entschichtungslösungen geringerer Konzentration, also z. B. 2 %ige statt 5 %ige Kalilauge bei im wesentlichen gleicher Wirkung zu verwenden.

Die belichteten Resistschablonen sind auch gegenüber aggressiven Verarbeitungslösungen, z. B. Goldbädern, beständig und haben eine gute Entwicklerrestenz.

Die erfindungsgemäßen Gemische bilden Trockenresistschichten, deren Scherviskosität im unbelichteten Zustand weniger von der Luftfeuchtigkeit abhängig ist als die von bekannten vergleichbaren Trockenresistmaterialien.

Das erfindungsgemäße Gemisch eignet sich außer für das Trockenresistverfahren auch für andere Anwendungen, bei denen es auf Flexibilität und Zähigkeit einer lichtempfindlichen Schicht ankommt, so z. B. für die Herstellung von Photoresistlösungen, von Druckformen, Reliefbildern, Siebdruckschablonen und Farbprüffolien.

Die folgenden Beispiele erläutern bevorzugte Ausführungsformen des erfindungsgemäßen Gemischs und ihre Anwendung. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu $cm^3$.

Beispiel 1

Die folgenden 5 Beschichtungslösungen wurden hergestellt:

| | |
|---|---|
| 5 | Gt eines Terpolymerisats aus Methylmethacrylat, n-Hexylmethacrylat und Methacrylsäure (5:60:35) mit dem mittleren Molekulargewicht $\overline{M}_w$ = 70.000, |
| 1,1 | Gt eines Diurethans aus 2 mol Hydroxyethylmethacrylat und 1 mol 2,2,4-Trimethyl-hexamethylendiisocyanat, |
| 3,9 | Gt einer unten angegebenen weiteren polymerisierbaren Verbindung, |
| 0,05 | Gt 9-Phenyl-acridin und |
| 0,01 | Gt eines blauen Azofarbstoffs, erhalten durch Kuppeln von 2,4-Dinitro-6-chlor-benzoldiazoniumsalz mit 2-Methoxy-5-acetylamino-N,N-diethylanilin, in |
| 16 | Gt Butanon und |
| 4 | Gt Ethanol |

Als weitere polymerisierbare Verbindungen wurden im einzelnen eingesetzt:

a) das Umsetzungsprodukt aus Hexapropylenglykolmonomethacrylat und Phenylisocyanat,

b) das Umsetzungsprodukt aus Hexapropylenglykolmonomethacrylat und m-Tolylisocyanat,

c) das Umsetzungsprodukt aus 1 mol Hydroxyethylacrylat, 2 mol Caprolacton und 1 mol n-Butylisocyanat,

d) das Umsetzungsprodukt aus Diethylenglykolmonomethacrylat und Butylisocyanat oder

e) das Umsetzungsprodukt aus 2 mol Hydroxyethylmethacrylat und 1 mol 2,2,4-Trimethylhexamethylendiisocyanat (Vergleich).

Die Lösungen wurden auf biaxial verstreckte und thermofixierte Polyethylenterephthalatfolien von 25 µm Stärke so aufgeschleudert, daß nach dem Trocknen bei 100° C jeweils ein Schichtgewicht von 45 g/m$^2$ erhalten wurde.

Die so hergestellten Trockenresistfolien wurden mit einer handelsüblichen Laminiervorrichtung bei 115° C auf mit 35 µm starker Kupferfolie kaschierte Phenoplast-Schichtstoffplatten laminiert und mittels einer 5-kW-Metallhalogenidlampe im Abstand von 110 cm zwischen Lampe und Vakuumkopierrahmen 4 s belichtet. Als Vorlage diente eine Strichvorlage mit Linienbreiten und Abständen bis herab zu 80 µm.

Nach der Belichtung wurden die Polyesterfolien abgezogen und die Schichten mit 1 %iger Natriumcarbonatlösung in einem Sprühentwicklungsgerät 60 s lang entwickelt.

Die Flexibilität der gehärteten Resistschichten wurde nach DIN 53 232 geprüft. Mit einem kammartigen Gitterschnittwerkzeug wurden parallele Schnitte von 1 mm Abstand in einer Richtung und in einer zweiten um 90° dazu geänderten Richtung durch die Resistschicht hindurch eingeritzt. Dann wurde ein druckempfindlicher Klebstreifen auf die Schichtoberfläche im Schnittbereich fest aufgedrückt und mit definierter Kraft und Geschwindigkeit abgezogen. Die Flexibilität und Haftung der Schicht wurde danach bewertet, wie die Schnittkanten aussahen und wieviel Prozent der Schnittquadrate vom Schichtträger abgelöst waren. Die Bewertung erfolgte auf einer Skala von Gt 0 bis Gt 4, wobei Gt 0 vollständig glatte, unbeschädigte Schnittkanten und 0 % Ablösung, Gt 4 starke streifenweise Absplitterung entlang der Schnittkanten und mindestens 65 % Ablösung von Schnittquadraten bedeutet.

Während die Resistschichten a) bis d) flexibel waren (Gt 0), war die Vergleichsschicht e) spröde (Gt 4). Die Flexibilität des Resists ist eine wesentliche Eigenschaft, die u. a. bei einer möglichen Retusche oder Korrektur eine Rolle spielt.

In einem weiteren Versuch wurden wie oben hergestellte und entwickelte Platten 30 s mit Leitungswasser gespült, 30 s in einer 15 %igen Ammoniumperoxydisulfat-Lösung angeätzt,, erneut mit Wasser gespült, 30 s in 10 %ige Schwefelsäure getaucht und sodann nacheinander in den folgenden Elektrolytbädern galvanisiert:

1. 60 Minuten in einem Kupferelektrolytbad der Firma Schlötter, Geislingen/Steige, Typ "Glanzkupfer-Bad"

| | |
|---|---|
| Stromdichte: | 2,5 A/dm$^2$ |
| Metallaufbau: | ca. 30 µm |
| Temperatur: | Raumtemperatur |

2. 15 Minuten in einem Bleizinnbad LA der Firma Schlötter, Geislingen/Steige

| | |
|---|---|
| Stromdichte: | 2 A/dm$^2$ |
| Metallaufbau: | 15 µm |
| Temperature: | Raumtemperatur |

Die Platten zeigten keinerlei Unterwanderungen oder Beschädigungen.

Die galvanisierten Platten wurden in 2 %iger Kaliumhydroxidlösung bei 50° C entschichtet. Für die Entschichtung waren die folgenden Zeiten erforderlich, wobei jeweils der erste Wert die Zeit bis zum Beginn, der zweite Wert die Zeit bis zum Ende der Entschichtung in Sekunden angibt:

a) 45-70 b) 45-65 c) 65-100 d) 50-80 e) 95-150

Es ist ersichtlich, daß durch den Zusatz der monofunktionellen Monomeren die Entschichtungszeit erheblich verkürzt wird. Gleichzeitig wird eine Verkleinerung der gebildeten Fladen beobachtet. Das bedeutet, daß der Resist auch aus engen Kanälen zwischen Leiterbahnen problemlos entfernt werden kann.

Beispiel 2

Auf 3 Polyesterfolien der in Beispiel 1 angegebenen Beschaffenheit wurden Lösungen folgender Zusammensetzung so aufgeschleudert, daß nach dem Trocknen ein Schichtgewicht von jeweils 30 $g/m^2$ erhalten wurde:

| | |
|---|---|
| 5 | Gt des in Beispiel 1 angegebenen Terpolymerisats, |
| x | Gt des Umsetzungsprodukts aus 2 mol Hydroxyethylmethacrylat und 1 mol 2,2,4-Trimethylhexamethylendiisocyanat, |
| y | Gt des Umsetzungsprodukts aus 1 mol Hydroxyethylacrylat, 2 mol Caprolacton und 1 mol n-Butylisocyanat, |
| 0,05 | Gt 9-Phenyl-acridin, |
| 0,006 | Gt des blauen Azofarbstoffs aus Beispiel 1 und |
| 0,024 | Gt des grünen Farbstoffs 1,4-Bis-(4-tert.-butoxy-phenylamino)-5,8-dihydroxy-anthrachinon in |
| 25 | Gt Butanon und |
| 5 | Gt Ethanol |

Die Mengenanteil der Monomeren in den einzelnen Gemischen waren wie folgt:
a) x = 2; y = 3 b) x = 1,1; y = 3,9 c) x = 0,5; y = 4,5
Die Materialien wurden wie in Beispiel 1 verarbeitet. In belichtetem Zustand waren alle Resistschichten flexibel. Zum Entschichten in 2 %iger Kalilauge bei 50° C wurden die folgenden Zeiten (Sekunden) benötigt:
a) 45 - 60 b) 25 - 30 c) 15 - 20
Die Abhängigkeit der Entschichtungszeit vom Mengenanteil an monofunktionellem Monomeren ist deutlich erkennbar.

Beispiel 3

Trockenresistmaterialien wurden mit Beschichtungslösungen gemäß Beispiel 2 hergestellt, die die folgenden Mengen an Monomeren enthielten:

| | |
|---|---|
| x | Gt des in Beispiel 2 angegebenen bifunktionellen Monomeren, |
| y | Gt des Umsetzungsprodukts von Hexapropylenglykolmonomethacrylat und m-Tolylisocyanat |

a) x = 2; y = 3 b) x = 1,1; y = 3,9 c) x = 0,5; y = 4,5
Zum Entschichten in 2 %iger Kalilauge bei 50° C wurden die folgenden Zeiten in Sekunden benötigt:
a) 35 - 45 b) 25 - 30 c) 15 - 25

Beispiel 4

Eine Beschichtungslösung aus

| | |
|---|---|
| 5 | Gt des in Beispiel 1 angegebenen Terpolymerisats, |
| 5 | Gt des Umsetzungsprodukts aus 1 mol Hydroxyethylacrylat, 2 mol Caprolacton und 1 mol n-Butylisocyanat, |
| 0,05 | Gt 9-Phenyl-acridin, |
| 0,006 | Gt des blauen Azofarbstoffs aus Beispiel 1 und |
| 0,024 | Gt des grünen Anthrachinonfarbstoffs aus Beispiel 2 in |
| 15 | Gt Butanon und |
| 5 | Gt Ethanol |

wurde auf die in Beispiel 1 beschriebene Polyesterfolie so aufeschleudert, daß nach dem Trocknen bei 100° C ein Schichtgewicht von 30 $g/m^2$ erhalten wurde. Die Schicht wurde auf eine mit einer 35 µm dicken Kupferfolie kaschierte Phenoplast-Schichtstoffplatte laminiert. Sie wurde dann mit einer Metallhalogenidlampe 6 Sekunden durch eine Leiterbild-Negativvorlage belichtet und nach Abziehen der Trägerfolie 60 Sekunden mit 1 %iger Natriumcarbonatlösung entwickelt.

Die freigelegten Kupferflächen wurden mit einer ammoniakalischen Kupferchlorid-Ätzlösung entfernt und der Resist mit 5 %iger Kalilauge bei 50° C entschichtet. Das Ätzergebnis war gut. Die Entschichtungszeit lag bei 25 bis 55 Sekunden, wobei sich die zunächst gebildeten Fladen nach etwa 12 Stunden vollständig in der Entschichtungslösung aufgelöst hatten. Besonders überraschend ist die gute Entwicklerreistenz der Resistschicht, die als polymerisierbare Verbindung ausschließlich ein monofunktionelles Monomeres enthält.

Zur Bestimmung der Entwicklerresistenz wurde 6 Sekunden durch einen 13-stufigen Belichtungskeil mit Dichtestufen von 0,15 belichtet und anschließend so lange mit 1 %iger Natriumcarbonatlösung entwickelt, bis die unbelichteten Bereiche gerade vollständig entfernt waren ($t_a$). Die ermittelte Keilstufenzahl wurde mit der verglichen, die bei der dreifachen Entwicklungszeit (3 x $t_a$) erhalten wurde:

| | $t_a$ | 3 x $t_a$ |
|---|---|---|
| Keilstufen | 8 (9) | 8 |

Beispiel 5

Durch Aufschleudern der im folgenden angegebenen Lösungen auf Polyesterfolien und anschließendes Trocknen wurden Trockenresistmaterialien mit 38 µm dicken Resistschichten hergestellt:

| | |
|---|---|
| 5,6 | Gt des in Beispiel 1 angegebenen Terpolymerisats, |
| 3,1 | Gt des Monomeren aus Beispiel 4, |
| 1,3 | Gt eines der unten angegebenen Polyglykolbismethacrylate, |
| 0,05 | Gt 9-Phenyl-acridin, |
| 0,006 | Gt des blauen Azofarbstoffs gemäß Beispiel 1 und |
| 0,024 | Gt des grünen Anthrachinonfarbstoffs gemäß Beispiel 2 in |
| 15 | Gt Butanon und |
| 5 | Gt Ethanol |

Als bifunktionelles Monomeres wurde a) das Bismethacrylat eines Polypropylenglykols mit dem Molekulargewicht 420 und im anderen Falle b) der entsprechende Ester eines Polyethylenglykols mit dem Molekulargewicht 400 eingesetzt. Die Photoresistschichten wurden wie in Beispiel 1 beschrieben verarbeitet. Zur Entschichtung nach dem Galvanisieren waren im Falle a) 30 - 70, im Falle b) 35 - 60 Sekunden erforderlich.

In einer weiteren Versuchsreihe wurden Trockenresistmaterialien gemäß a) und b) auf mit Kupfer kaschierte Testplatten mit Bohrungen zwischen 1 und 6 mm Durchmesser auflaminiert und durch eine den Bohrungen entsprechende Negativvorlage (Durchmesser der transparenten Stellen 1, 4 bis 6,4 mm) belichtet. Anschliessend wurden die nicht belichteten Schichtteile mit 1%iger Natriumcarbonatlösung ausgewaschen und das freigelegte Kupfer mit ammoniakalischer Kupferchloridlösung weggeätzt. Nach dem Ätzen waren alle Bohrlöcher mit gehärtetem Photoresist überspannt.

Beispiel 6

Wie in Beispiel 1c und 5a beschrieben, wurden Trockenresistmaterialien hergestellt, auf kupferkaschierte Isolierstoffplatten laminiert, belichtet und entwickelt. Die erhaltenen strukturierten Platten wurden dann wie folgt galvanisiert:

1.) 60 Minuten in einem Kupferelektrolytbad der Firma Blasberg, Solingen, Typ "Cuprostar LP 1"

| | |
|---|---|
| Stromdichte: | 2,0 A/dm$^2$ |
| Metallaufbau: | ca. 24 µm |
| Temperatur: | Raumtemperatur |

2.) 15 Minuten in einem Nickelbad, Typ "Norma", der Firma Schlötter, Geislingen/Steige

| | |
|---|---|
| Stromdichte: | 3,5 A/dm$^2$ |
| Metallaufbau: | 12 µm |
| Temperatur: | 50° C |

3.) 10 Minuten in einem Goldbad der Firma Blasberg, Solingen, Typ "Autronex CC"

| | |
|---|---|
| Stromdichte: | 1,0 A/dm$^2$ |
| Metallaufbau: | 3 µm |
| Temperatur: | Raumtemperatur |

Die Platten zeigten keine Unterwanderungen oder Beschädigungen.

Beispiel 7

Es wurde wie in Beispiel 1 gearbeitet, jedoch wurden als monofunktionelle polymerisierbare Verbindungen jeweils eine der folgenden eingesetzt:

a) das Umsetzungsprodukt aus Hydroxyethylmethacrylat und n-Butylisocyanat,

b) das Umsetzungsprodukt aus 1 mol Hydroxyethylmethacrylat, 2 mol Caprolacton und 1 mol n-Butylisocyanat,

c) das Umsetzungsprodukt aus Hexapropylenglykolmonomethacrylat und n-Butylisocyanat.

Mit den erhaltenen Trockenresistmaterialien wurden ähnliche Ergebnisse wie in Beispiel 1 erhalten.

Beispiel 8

Ein Trockenresistmaterial wurde entsprechend Beispiel 1c hergestellt. Zum Vergleich wurde ein weiteres sonst gleiches Material hergestellt, das anstelle des monofunktionellen Monomeren von Beispiel 1c die gleiche Menge des Umsetzungsprodukts aus 1 mol Hydroxyethylacrylat und 2 mol Caprolacton enthielt. Die Materialien wurden wie in Beispiel 1 auf Kupfer laminiert, 6 Sekunden belichtet und entwickelt. Die Flexibilität und Haftung der unbelichteten Schichten wurden wie in Beispiel 1 geprüft. Ferner wurde die Entwicklerresistenz wie in Beispiel 4 geprüft.

Die folgende Tabelle zeigt die Ergebnisse:

| Resist | Haftung auf Cu | Entwicklerresistenz, Keilstufen | |
|---|---|---|---|
| | | $t_a$ | $t_a$ x 3 |
| 1 c | Gt 0 | 8 (9) | 8 |
| Vergleich | Gt 4 | 6 (7-9) | 4 (5-8) |

Neben einer deutlich schlechteren Haftung fällt bei der Vergleichsschicht die große Anzahl der teilvernetzten Stufen sowie die schlechtere Entwicklerresistenz auf.

Beispiel 9

Es wurden Beschichtungslösungen der folgenden Zusammensetzung hergestellt:

a)

| | |
|---|---|
| 5 | Gt des in Beispiel 1 angegebenen Terpolymerisats, |
| 1,1 | Gt des in Beispiel 1 angegebenen bifunktionellen Monomeren, |
| 3,9 | Gt des Umsetzungsprodukts aus Diethylenglykolmonomethacrylat und n-Butylisocryanat, |
| 0,05 | Gt 9-Phenyl-acridin und |
| 0,016 | Gt des in Beispiel 1 angegebenen blauen Azofarbstoffs in |
| 16 | Gt Butanon und |
| 4 | Gt Ethanol |

b) gleiche Lösung wie unter a), worin jedoch das monofunktionelle Monomere durch die gleiche Menge Phenoxyethoxyethylacrylat ersetzt war (Vergleich)

c) gleiche Lösung wie unter a), worin jedoch das monofunktionelle Monomere durch die gleiche Menge Hydrochinonmonomethacrylat ersetzt war (Vergleich).

d) (Vergleich)

| | |
|---|---|
| 5 | Gt des in Beispiel 1 angegebenen Terpolymerisats, |
| 5 | Gt einer handelsüblichen Lösung von 65 Gt eines Urethangruppen enthaltenden Bisacrylats, in 35 Gt. Phenoxyethylacrylat (Laromer LR 8642x der BASF AG), |
| 0,05 | Gt 9-Phenyl-acridin und |
| 0,016 | Gt des in Beispiel 1 angegebenen blauen Azofarbstoffs in |
| 16 | Gt Butanon und |
| 4 | Gt Ethanol |

e) (Vergleich)

| | |
|---|---|
| 40 | Gt des in Beispiel 1 angegebenen Terpolymerisats, |

12 Gt Trimethylolpropantriacrylat,
10 Gt Phenoxyethoxyethylacrylat,
0,312 Gt 9-Phenyl-acridin und
0,096 Gt des in Beispiel 1 angegebenen blauen Azofarbstoffs in
100 Gt Butanon und
25 Gt Ethanol

Die Lösungen wurden auf Polyesterfolien des in Beispiel 1 angegebenen Typs aufgeschleudert und getrocknet; das Schichtgewicht betrug jeweils 45 g/m$^2$. Die Trockenresistmaterialien wurden dann in einem handelsüblichen Laminator bei 115° C auf kupferkaschierte Isolierstoffplatten laminiert. Die Haftung der unbelichteten Schichten wurde nach dem in Beispiel 1 beschriebenen Gitterschnittest geprüft. Die folgende Tabelle zeigt die Ergebnisse.

| | a | b | c | d | e |
|---|---|---|---|---|---|
| Haftung | Gt 0 | >Gt 4 | >Gt 4 | >Gt 4 | >Gt 4 |

Bei der Lagerung kristallisierte aus der Schicht c) das monofunktionelle Monomere aus.

Beispiel 10

Eine Beschichtungslösung aus
5 Gt des in Beispiel 1 angegebenen Terpolymerisats,
1,5 Gt des in Beispiel 1 angegebenen Bismethacrylats,
3,5 Gt des in Beispiel 1c angegebenen monofunktionellen Monomeren,
0,05 Gt 9-Phenyl-acridin und
0,01 Gt des in Beispiel 1 angegebenen blauen Azofarbstoffs in
16 Gt Butanon und
4 Gt Ethanol

wurde auf eine Polyesterfolie wie in Beispiel 1 aufgeschleudert und getrocknet. Zwei wie vorstehend beschrieben hergestellte Trockenresistfolien wurden in einem Laminiergerät aufeinanderlaminiert. Nach dem Abziehen einer Trägerfolie wurde nochmals eine Resistschicht und schließlich eine vierte Resistschicht mit den übrigen durch Laminieren vereinigt.

In einem zweiten Versuch wurde wie oben verfahren, jedoch wurde in der Beschichtungslösung das monofunktionelle Monomere durch die gleiche Menge des dort angegebenen Bismethacrylats ersetzt (Vergleich). Auch von diesem Material wurde ein Sandwich-Laminat mit einer Resistschicht vierfacher Dicke in gleicher Weise wie oben hergestellt.

Proben der beiden Laminate wurden jeweils bei 0 % und bei 53 % relativer Feuchte gelagert. Von diesen Proben wurde dann die Scherviskosität (in MPa•s) bei 40° C gemessen. Bei dem erfindungsgemäßen Material war das Verhältnis der Scherviskositäten bei 0 %/53 % rel. Feuchte 1,7; bei dem Vergleichsversuch war das entsprechende Verhältnis 4,5. Der Versuch zeigt, daß die Abhängigkeit der Scherviskosität der unbelichteten Resistschicht, die ein Maß für den kalten Fluß der Schicht ist, von der Luftfeuchte bei dem erfindungsgemäßen Material wesentlich kleiner ist als bei dem Material ohne monofunktionelles Monomeres.

## Patentansprüche

**1.** Durch Strahlung polymerisierbares Gemisch, das als wesentliche Bestandteile

a) ein polymeres Bindemittel, das wasserunlöslich und in wäßrig-alkalischen Lösungen löslich oder mindestens quellbar ist oder das ein Polyacrylsäureester oder Polymethacrylsäureester ist,

b) ein radikalisch polymerisierbares Acryl- oder Alkacrylsäurederivat mit einem Siedepunkt oberhalb 100° C bei Normaldruck und

c) eine Verbindung oder eine Verbindungskombination, die unter Einwirkung aktinischer Strahlung die Polymerisation der Verbindung b) zu initiieren vermag,

enthält, dadurch gekennzeichnet, daß das Acryl- oder Alkacrylsäurederivat eine Verbindung der Formel I

$$CH_2 = C(R^1) - CO - A - (C_mH_{2m}O)_n - (Q)_l - CO - NHR^2 \quad (I)$$

ist, worin

A O, NH oder N-Alkyl,
Q $-CO-C_pH_{2p}-Z-$ oder $-C_kH_{2k}O-$,
Z O oder NH,
$R^1$ H oder Alkyl,
$R^2$ Alkyl, Alkenyl, Cycloalkyl, Aryl, Aralkyl oder $SO_2R^3$,
$R^3$ Alkyl, Alkenyl, Cycloalkyl, Aryl, Aralkyl oder Aryloxy,
k eine Zahl von 3 bis 20,
l eine Zahl von 0 bis 20,
m eine Zahl von 2 bis 20,
n eine Zahl von 1 bis 20 und
p eine Zahl von 2 bis 10

bedeutet.

**2.** Durch Strahlung polymerisierbares Gemisch nach Anspruch 1, dadurch gekennzeichnet, daß es zusätzlich eine radikalisch polymerisierbare Verbindung mit einem Siedepunkt oberhalb 100° C bei Normaldruck enthält, die mindestens zwei ethylenisch ungesättigte polymerisierbare Gruppen aufweist.

**3.** Durch Strahlung polymerisierbares Gemisch nach Anspruch 1, dadurch gekennzeichnet, daß es eine Verbindung der Formel I enthält, worin A und Z Sauerstoffatome sind.

**4.** Durch Strahlung polymerisierbares Gemisch nach Anspruch 1, dadurch gekennzeichnet, daß es eine Verbindung der Formel I enthält, woring l = 0 bis 10 und p = 3 bis 6 ist.

**5.** Durch Strahlung polymerisierbares Gemisch nach Anspruch 1, dadurch gekennzeichnet, daß es 25 bis 75 Gew.-% an polymeren Bindemitteln, 25 bis 75 Gew.-% an radikalisch polymerisierbaren Verbindungen und 0,01 bis 10 Gew.-% an Initiatoren bzw. Initiatorkombinationen, bezogen auf die Gesamtmenge an nichtflüchtigen Bestandteilen, enthält.

**6.** Durch Strahlung polymerisierbares Gemisch nach Anspruch 2, dadurch gekennzeichnet, daß es 5 bis 100 Gew.-% an Verbindungen der Formel I und 0 bis 95 Gew.-% an polymerisierbaren Verbindungen mit mindestens zwei polymerisierbaren Gruppen, bezogen auf die Gesamtmenge an polymerisierbaren Verbindungen, enthält.

**7.** Durch Strahlung polymerisierbares Aufzeichnungsmaterial mit einem flexiblen transparenten temporären Schichtträger und einer übertragbaren thermoplastischen durch Strahlung polymerisierbaren Photoresistschicht, die als wesentliche Bestandteile

a) ein polymeres Bindemittel, das wasserunlöslich und in wäßrig-alkalischen Lösungen löslich oder mindestens quellbar ist oder das ein Polyacrylsäureester oder Polymethacrylsäureester ist,

b) ein radikalisch polymerisierbares Acryl- oder Alkacrylsäurederivat mit einem Siedepunkt oberhalb 100° C bei Normaldruck und

c) ein Verbindung oder eine Verbindungskombination, die unter Einwirkung aktinischer Strahlung die Polymerisation der Verbindung b) zu initiieren vermag,

enthält, und gegebenenfalls einem abziehbaren Deckblatt auf der freien Seite der Photoresistschicht, das an dieser Schicht weniger stark haftet als der temporäre Schichtträger, dadurch gekennzeichnet, daß das Acryl-oder Alkacrylsäurederivat eine Verbindung der Formel I

$$CH_2 = \overset{\overset{R^1}{|}}{C} - CO - A - (C_mH_{2m}O)_n - (Q)_l - CO - NHR^2 \quad (I)$$

ist, worin

- A  O, NH oder N-Alkyl,
- Q  $-CO-C_pH_{2p}-Z-$ oder $-C_kH_{2k}O-$,
- Z  O oder NH,
- $R^1$  H oder Alkyl,
- $R^2$  Alkyl, Alkenyl, Cycloalkyl, Aryl, Aralkyl oder $SO_2R^3$,
- $R^3$  Alkyl, Alkenyl, Cycloalkyl, Aryl, Aralkyl oder Aryloxy,
- k  eine Zahl von 3 bis 20,
- l  eine Zahl von 0 bis 20,
- m  eine Zahl von 2 bis 20,
- n  eine Zahl von 1 bis 20 und
- p  eine Zahl von 2 bis 10

bedeutet.

**8.** Verfahren zur Herstellung von Reliefaufzeichnungen, bei dem man eine trockene, feste, durch Strahlung polymerisierbare Photoresistschicht, die als wesentliche Bestandteile

a) ein polymeres Bindemittel, das wasserunlöslich und in wäßrig-alkalischen Lösungen löslich oder mindestens quellbar ist oder das ein Polyacrylsäureester oder Polymethacrylsäureester ist,

b) ein radikalisch polymerisierbares Acryl- oder Alkacrylsäurederivat mit einem Siedepunkt oberhalb 100° C bei Normaldruck und

c) eine Verbindung oder eine Verbindungskombination, die unter Einwirkung aktinischer Strahlung die Polymerisation der Verbindung b) zu initiieren vermag,

enthält und die sich auf einem flexiblen transparenten temporären Schichtträger befindet, unter Druck und Erwärmen auf einen endgültigen Schichtträger laminiert, bildmäßig bestrahlt, den temporären Schichtträger abzieht und die unbestrahlten Schichtbereiche mit einem Entwickler auswäscht, dadurch gekennzeichnet, daß die Photoresistschicht als radikalisch polymerisierbares Acryl- oder Alkacrylsäurederivat eine Verbindung der Formel I

$$CH_2 = \overset{\overset{R^1}{|}}{C} - CO - A - (C_mH_{2m}O)_n - (Q)_l - CO - NHR^2 \quad (I)$$

enthält, worin

- A  O, NH oder N-Alkyl,
- Q  $-CO-C_pH_{2p}-Z-$ oder $-C_kH_{2k}O-$,
- Z  O oder NH,
- $R^1$  H oder Alkyl,
- $R^2$  Alkyl, Alkenyl, Cycloalkyl, Aryl, Aralkyl oder $SO_2R^3$,
- $R^3$  Alkyl, Alkenyl, Cycloalkyl, Aryl, Aralkyl oder Aryloxy,
- k  eine Zahl von 3 bis 20,
- l  eine Zahl von 0 bis 20,
- m  eine Zahl von 2 bis 20,
- n  eine Zahl von 1 bis 20 und
- p  eine Zahl von 2 bis 10

bedeutet.

## Claims

**1.** A radiation-polymerizable mixture, containing as the essential constituents

a) polymeric binder, which is insoluble in water and soluble or at least swellable in aqueous-alkaline solutions or which is an ester of polyacrylic or polymethacrylic acid,

b) an acrylic or alkacrylic derivative polymerizable by free radicals and having a boiling point above 100 °C under normal pressure and

c) a compound or a combination of compounds, which is capable of initiating the polymerization of the compound b) under the action of actinic radiation,

wherein the acrylic or alkacrylic acid derivative is a compound of the formula I

$$CH_2 = \overset{\overset{\displaystyle R^1}{|}}{C} - CO - A - (C_mH_{2m}O)_n - (Q)_l - CO - NHR^2 \qquad (I)$$

in which

A is O, NH or N-alkyl,
Q is $-CO-C_pH_{2p}-Z-$ or $-C_kH_{2k}O-$,
Z is O or NH,
$R^1$ is H or alkyl,
$R^2$ is alkyl, alkenyl, cycloalkyl, aryl, aralkyl or $SO_2R^3$,
$R^3$ is alkyl, alkenyl, cycloalkyl, aryl, aralkyl or aryloxy,
k is a number from 3 to 20,
l is a number from 0 to 20,
m is a number from 2 to 20,
n is a number from 1 to 20 and
p is a number from 2 to 10.

**2.** A radiation-polymerizable mixture as claimed in claim 1, which additionally contains a compound which is polymerizable by free radicals, has a boiling point above 100 °C under normal pressure and contains at least two ethylenically unsaturated polymerizable groups.

**3.** A radiation-polymerizable mixture as claimed in claim 1, which contains a compound of the formula I in which A and Z are oxygen atoms.

**4.** A radiation-polymerizable mixture as claimed in claim 1, which contains a compound of the formula I wherein l = 0 to 10 and p = 3 to 6.

**5.** A radiation-polymerizable mixture as claimed in claim 1, which contains 25 to 75 % by weight of polymeric binders, 25 to 75 % by weight of compounds polymerizable by free radicals and 0.01 to 10 % by weight of initiators or initiator combinations, relative to the total quantity of non-volatile constituents.

**6.** A radiation-polymerizable mixture as claimed in claim 2, which contains, relative to the total quantity of polymerizable compounds, 5 to 100 % by weight of compounds of the formula I and 0 to 95 % by weight of polymerizable compounds with at least two polymerizable groups.

**7.** A radiation-polymerizable recording material with a flexible transparent temporary support and a transferable thermoplastic radiation-polymerizable photoresist layer containing as the essential constituents

a) polymeric binder, which is insoluble in water and soluble or at least swellable in aqueous-alkaline solutions or which is an ester of polyacrylic or polymethacrylic acid,

b) an acrylic or alkacrylic acid derivative polymerizable by free radicals and having a boiling point above 100 °C under normal pressure and

c) a compound or a combination of compounds, which is capable of initiating the polymerization of the compound b) under the action of actinic radiation,

and, if appropriate, on the free side of the photoresist layer, a cover sheet which can be peeled off and which adheres less strongly to this layer than the temporary support, wherein the acrylic or alkacrylic acid derivative is a compound of the formula I

$$CH_2 = C(R^1) - CO - A - (C_mH_{2m}O)_n - (Q)_l - CO - NHR^2 \quad (I)$$

in which

- A is O, NH or N-alkyl,
- Q is $-CO-C_pH_{2p}-Z-$ or $-C_kH_{2k}O-$,
- Z is O or NH,
- $R^1$ is H or alkyl,
- $R^2$ is alkyl, alkenyl, cycloalkyl, aryl, aralkyl or $SO_2R^3$,
- $R^3$ is alkyl, alkenyl, cycloalkyl, aryl, aralkyl or aryloxy,
- k is a number from 3 to 20,
- l is a number from 0 to 20,
- m is a number from 2 to 20,
- n is a number from 1 to 20 and
- p is a number from 2 to 10.

**8.** A process for the preparation of relief recordings, in which a dry, solid, radiation-polymerizable photoresist layer containing as the essential constituents

a) polymeric binder, which is insoluble in water and soluble or at least swellable in aqueous-alkaline solutions or which is an ester of polyacrylic or polymethacrylic acid,

b) an acrylic or alkacrylic derivative polymerizable by free radicals and having a boiling point above 100 °C under normal pressure and

c) a compound or a combination of compounds, which is capable of initiating the polymerization of the compound b) under the action of actinic radiation,

and located on a flexible transparent temporary support, is laminated under pressure and with heating to a final support and is irradiated imagewise, the temporary support is peeled off and the unirradiated layer areas are washed out with a developer, wherein the photoresist layer contains, as the acrylic or alkacrylic acid derivative polymerizable by free radicals, a compound of the formula I

$$CH_2 = C(R^1) - CO - A - (C_mH_{2m}O)_n - (Q)_l - CO - NHR^2 \quad (I)$$

in which

- A is O, NH or N-alkyl,
- Q is $-CO-C_pH_{2p}-Z-$ or $-C_kH_{2k}O-$,
- Z is O or NH,
- $R^1$ is H or alkyl,
- $R^2$ is alkyl, alkenyl, cycloalkyl, aryl, aralkyl or $SO_2R^3$,
- $R^3$ is alkyl, alkenyl, cycloalkyl, aryl, aralkyl or aryloxy,
- k is a number from 3 to 20,
- l is a number from 0 to 20,
- m is a number from 2 to 20,
- n is a number from 1 to 20 and
- p is a number from 2 to 10.

## Revendications

**1.** Composition polymérisable par irradiation, contenant en tant que composants essentiels

a) un liant polymère qui est insoluble dans l'eau et soluble ou au moins susceptible de gonfler dans

des solutions aqueuses-alcalines ou qui est un polyester d'acide acrylique ou un polyester d'acide méthacrylique,

b) un dérivé d'acide acrylique ou alkacrylique, polymérisable par polymérisation radicalaire, ayant un point d'ébullition de plus de 100 °C sous la pression normale, et

c) un composé ou une association de composés qui est capable, sous l'effet d'un rayonnement actinique, de déclencher la polymérisation du composé b),

caractérisé en ce que le dérivé d'acide acrylique ou alkacrylique est un composé de formule I

$$CH_2{=}C(R^1){-}CO{-}A{-}(C_mH_{2m}O)_n{-}(Q)_l{-}CO{-}NHR^2 \qquad (I)$$

dans laquelle

- A représente O, NH ou un groupe N-alkyle,
- Q représente $-CO-C_pH_{2p}-Z-$ ou $C_kH_{2k}O-$,
- Z représente O ou NH,
- $R^1$ représente H ou groupe alkyle,
- $R^2$ représente un groupe alkyle, alcényle, cycloalkyle, aryle, aralkyle ou $SO_2R^3$,
- $R^3$ représente un groupe alkyle, alcényle, cycloalkyle, aryle, aralkyle ou aryloxy,
- k est un nombre allant de 3 à 20,
- l est un nombre allant de 0 à 20,
- m est un nombre allant de 2 à 20,
- n est un nombre allant de 1 à 20 et
- p est un nombre allant de 2 à 10.

2. Composition polymérisable par irradiation selon la revendication 1, caractérisée en ce qu'elle contient en outre un composé polymérisable par polymérisation radicalaire, ayant un point d'ébullition de plus de 100 °C sous la pression normale, qui comporte au moins deux groupes polymérisables à insaturation éthylénique.

3. Composition polymérisable par irradiation selon la revendication 1, caractérisée en ce qu'elle contient un composé de formule 1 dans lequel A et Z sont des atomes d'oxygène.

4. Composition polymérisable par irradiation selon la revendication 1, caractérisée en ce qu'elle contient un composé de formule I dans lequel l va de 0 à 10 et p va de 3 à 6.

5. Composition polymérisable par irradiation selon la revendication 1, caractérisée en ce qu'elle contient de 25 à 75 % en poids de liants polymères, de 25 à 75 % en poids de composés polymérisables par polymérisation radicalaire et de 0,01 à 10 % en poids d'initiateurs ou d'associations d'initiateurs, par rapport à la quantité totale de composants non volatils.

6. Composition polymérisable par irradiation selon la revendication 2, caractérisée en ce qu'elle contient de 5 à 100 % en poids de composés de formule I et de 0 à 95 % en poids de composés polymérisables comportant au moins deux groupes polymérisables, par rapport à la quantité totale de composés polymérisables.

7. Matériau de reprographie polymérisable par irradiation, comportant un support de couche temporaire transparent flexible et une couche de photorésist thermoplastique transférable, polymérisable par irradiation, qui contient, en tant que composants essentiels

a) un liant polymère qui est insoluble dans l'eau et soluble ou au moins susceptible de gonfler dans des solutions aqueuses-alcalines ou qui est un polyester d'acide acrylique ou un polyester d'acide méthacrylique,

b) un dérivé d'acide acrylique ou alkacrylique, polymérisable par polymérisation radicalaire, ayant un point d'ébullition de plus de 100 °C sous la pression normale, et

c) un composé ou une association de composés qui est capable, sous l'effet d'un rayonnement actinique, de déclencher la polymérisation du composé b),

et éventuellement une feuille de recouvrement détachable sur le côté libre de la couche de photorésist, qui adhère moins fortement à cette couche que le support de couche temporaire, caractérisé en ce que le dérivé d'acide acrylique ou alkacrylique est un composé de formule I

$$CH_2=\overset{R^1}{\overset{|}{C}}-CO-A-(C_mH_{2m}O)_n-(Q)_l-CO-NHR^2 \qquad (I)$$

dans laquelle

- A représente O, NH ou un groupe N-alkyle,
- Q représente $-CO-C_pH_{2p}-Z-$ ou $C_kH_{2k}O-$,
- Z représente O ou NH,
- $R^1$ représente H ou groupe alkyle,
- $R^2$ représente un groupe alkyle, alcényle, cycloalkyle, aryle, aralkyle ou $SO_2R^3$,
- $R^3$ représente un groupe alkyle, alcényle, cycloalkyle, aryle, aralkyle ou aryloxy,
- k est un nombre allant de 3 à 20,
- l est un nombre allant de 0 à 20,
- m est un nombre allant de 2 à 20,
- n est un nombre allant de 1 à 20 et
- p est un nombre allant de 2 à 10.

**8.** Procédé pour l'obtention de reproductions en relief, dans lequel on applique par laminage sur un support de couche final, sous pression et en chauffant, une couche de photorésist sèche, solide, polymérisable par irradiation, qui contient, en tant que composants essentiels

a) un liant polymère qui est insoluble dans l'eau et soluble ou au moins susceptible de gonfler dans des solutions aqueuses-alcalines ou qui est un polyester d'acide acrylique ou un polyester d'acide méthacrylique,

b) un dérivé d'acide acrylique ou alkacrylique, polymérisable par polymérisation radicalaire, ayant un point d'ébullition de plus de 100 °C sous la pression normale, et

c) un composé ou une association de composés qui est capable, sous l'effet d'un rayonnement actinique, de déclencher la polymérisation du composé b),

et qui se trouve sur un support de couche flexible transparent temporaire, on l'irradie selon l'image, on enlève le support de couche temporaire et on élimine par lavage avec un révélateur les zones de couche non irradiées, caractérisé en ce que la couche de photorésist contient, en tant que dérivé d'acide acrylique ou alkacrylique polymérisable par polymérisation radicalaire, un composé de formule I

$$CH_2=\overset{R^1}{\overset{|}{C}}-CO-A-(C_mH_{2m}O)_n-(Q)_l-CO-NHR^2 \qquad (I)$$

dans laquelle

- A représente O, NH ou un groupe N-alkyle,
- Q représente $-CO-C_pH_{2p}-Z-$ ou $C_kH_{2k}O-$,
- Z représente O ou NH,
- $R^1$ représente H ou groupe alkyle,
- $R^2$ représente un groupe alkyle, alcényle, cycloalkyle, aryle, aralkyle ou $SO_2R^3$,
- $R^3$ représente un groupe alkyle, alcényle, cycloalkyle, aryle, aralkyle ou aryloxy,
- k est un nombre allant de 3 à 20,
- l est un nombre allant de 0 à 20,
- m est un nombre allant de 2 à 20,
- n est un nombre allant de 1 à 20 et
- p est un nombre allant de 2 à 10.